Europäisches Patentamt

European Patent Office

Office européen des brevets

(11) Veröffentlichungsnummer: **0 277 321**
**A1**

## (12) EUROPÄISCHE PATENTANMELDUNG

(21) Anmeldenummer: 87118442.0

(22) Anmeldetag: **12.12.87**

(51) Int. Cl.⁴: **G01R 31/36**

(30) Priorität: **29.01.87 DE 3702591**

(43) Veröffentlichungstag der Anmeldung:
**10.08.88 Patentblatt 88/32**

(84) Benannte Vertragsstaaten:
**AT BE ES FR GB**

(71) Anmelder: **ACCUMULATORENFABRIK
SONNENSCHEIN GMBH
Thiergarten Postfach 1180
D-6470 Büdingen 1 Oberhessen(DE)**

(72) Erfinder: **Geuer, Wolfgang, Dipl.-Ing.
Ravelsberger Str. 45
D-5102 Würselen(DE)**
Erfinder: **Lürkens, Peter, Dipl.-Ing.
Alexianergraben 21
D-5100 Aachen(DE)**
Erfinder: **Schöner, Hans Peter, Dipl.-Ing.
Jahnplatz 3
D-5100 Aachen(DE)**

(74) Vertreter: **Baumann, Eduard, Dipl.-Phys.
Postfach 1201 Sattlerstrasse 1
D-8011 Höhenkirchen/München(DE)**

(54) **Schaltung zur laufenden Überprüfung der Qualität einer mehrzelligen Batterie.**

(57) Für spezielle Einsatzzwecke ist eine laufende Qualitätsüberwachung der Batterie erforderlich. Ein Maß hierfür bildet die Zellenspannung, der unter bestimmten Bedingungen entnehmbare Strom sowie weitere Werte, beispielsweise die Zellentemperatur.

Bisher wurden für derartige Messungen eine große Anzahl von Kabeln, nämlich für jede Zelle und jeden Meßfühler, verwendet. Bei größeren Zellenanordnungen, beispielsweise für eine 220 Volt-Anlage mit 110 Zellen, ist ein derartiges Verfahren schon wegen des Kabelwirrwarrs praktisch nicht mehr möglich.

Ziel ist die Schaffung einer Schaltung, bei der der Kabelaufwand erheblich reduziert wird und dennoch eine sichere und zuverlässige Aussage über die Qualität einer Batterie möglich ist.

An jede Zelle oder eine Gruppe von mehreren Zellen (18) je eine Meßschaltung angeschaltet, die über eine gemeinsame Steuerleitung und/oder Meßleitung ausgelöst wird, wobei diese Werte nacheinander über eine gemeinsame Meßleitung einer gemeinsamen Auswerteschaltung zugeführt werden.

Die Auswerteschaltung kann mit einer gemeinsamen Anziegeeinrichtung verbunden sein.

Fig. 1

## Schaltung zur laufenden überprüfung der Qualität einer mehrzelligen Batterie

Die Erfindung betrifft eine Schaltung gemäß dem Oberbegriff des Anspruches 1.

Als Maß für diese überprüfung soll bei hintereinander geschalteten Zellen primär der Vergleich der Einzelzellenspannungen oder der Vergleich der Spannungen einzelner Zellengruppen untereinander und mit gespeicherten Bezugswerten dienen. Bei parallel geschalteten Zellen kann stattdessen oder zusätzlich der Zellenstrom für die überwachung ausgewertet werden. Aus beiden Informationen ist ein Rückschluß auf den Innenwiderstand der Zellen möglich, welcher signifikante Aussagen über den Zustand der Zellen zuläßt. Weiterhin ist z. B. die Temperatur der einzelnen Zellen von großer Bedeutung für eine Optimierung des Ladeverfahrens.

Derartige Schaltungen und Verfahren sind beispielsweise für die Entwicklung von Batterien von Bedeutung, um deren Lebensdauer zu optimieren, oder zur einfachen Fernabfrage des Qualitätszustandes von großen Batterieanlagen verschiedenster Einsatzzwecke, z. B. bei Notaggregaten, da insbesondere bei extrem beanspruchten Batterien das Verhalten der schwächsten Zelle die Behandlung der gesamten Batterie bestimmen sollte.

Bisher war es üblich, die Spannungen der einzelnen Zellen über einzelne elektrische Kabel zu einer zentralen Meßwerterfassung zu leiten und dort auszuwerten. Aufgrund der parallelen Verlegung von Meßkabeln mit hohen Potentialdifferenzen treten Gefahren auf, zumal diese Kabel im allgemeinen in aggressiver und explosiver Umgebung verlegt werden müssen. Darüberhinaus bedeutet die große Anzahl von zu verlegenden Kabeln einen hohen Aufwand und eine gewisse Störanfälligkeit gegen elektrische und magnetische Felder, welche in der Nähe von Batterien sehr ausgeprägt sein können.

Der Erfindung liegt die Aufgabe zugrunde, eine Schaltung gemäß dem Oberbegriff des Anspruches 1 so auszugestalten, daß bei einfachem Aufbau eine sichere Ermittlung der Spannung und/oder anderer kontinuierlich veränderlicher physikalischer oder chemischer Größen wie Strom, Temperatur jeder einzelnen Zelle oder von Zellengruppen vielzelliger Batterien und daraus eine einfache und sichere laufende überprüfung der Qualität einer mehrzelligen Batterie ermöglicht wird. Hierbei soll insbesondere die Verlegung von elektrischen Leitungen auf ein Minimum beschränkt werden.

Die Aufgabe wird erfindungsgemäß durch die Merkmale des Kennzeichens des Anspruches 1 gelöst. Weitere Ausgestaltungen der Erfindung sind in den Unteransprüchen unter Schutz gestellt.

Ausführungsbeispiele sind in der Zeichnung dargestellt. Es zeigt:

Figur 1 ein Gesamtschema der Schaltung,

Figur 2 ein spezielles Ausführungsbeispiel unter Verwendung von Optokopplern in schematischer Darstellung,

Figur 3 die Schaltung eines üblichen Meßwandlers,

Figur 4 die Gesamtschaltung einer Meßschaltung gemäß Figur 1,

Figur 5 eine Anpassungsschaltung gemäß Figur 1 für die Verwendung bei einer Schaltung, bei der eine Meßschaltung für mehrere Zellen Verwendung findet,

Figur 6 die Darstellung von Figur 2, wobei jedoch Steuerleitung und Meßleitung zusammenfallen.

Figur 7 einen Spezialfall des Gesamtschemas gemäß Figur 1, wobei eine einzige Steuerleitung vorgesehen ist, die gleichzeitig die gemeinsame Meßleitung bildet.

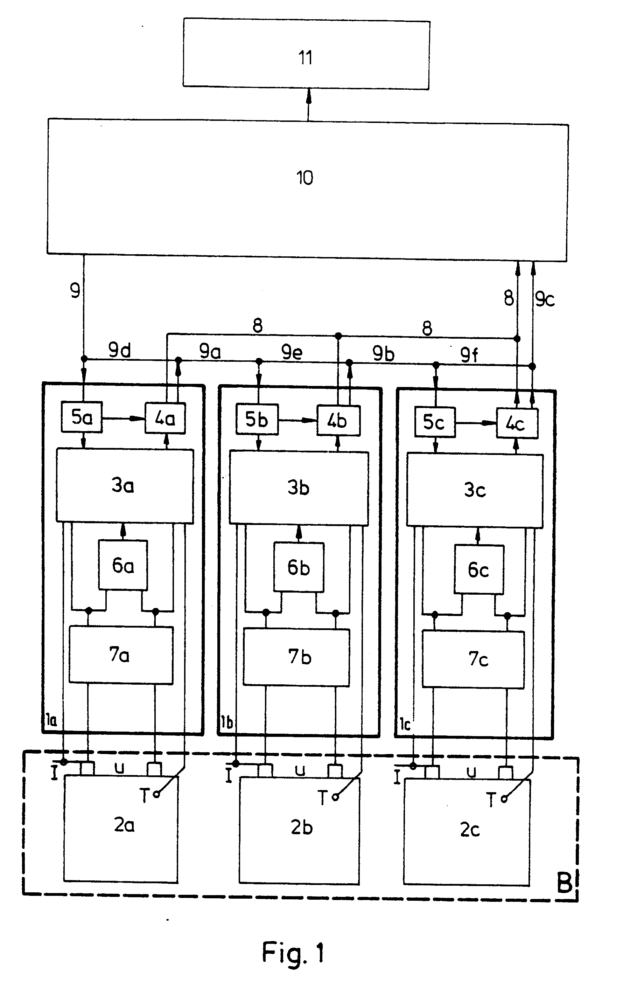

In der Zeichnung sind gleiche Teile mit gleichen Bezugszeichen versehen. In der schematischen Darstellung von Figur 1 sind als Beispiel drei nebeneinanderliegende Zellen 2a, 2b und 2c angegeben. Die Anzahl der Zellen kann beliebig vergrößert werden. Darüberhinaus ist es auch möglich, statt einer einzelnen Zelle jeweils eine Gruppe von Zellen zusammenzufassen und an eine gemeinsame Meßschaltung anzuschließen.

Gemäß Figur 1 ist an jede der Zellen 2a, 2b und 2c eine allgemein mit 1a, 1b und 1c bezeichnete Meßschaltung angeschlossen. Die Zellenklemmen sind mit einer Spannungsanpassung 7a, 7b beziehungsweise 7c verbunden. Von dieser Spannungsanpassung führen zwei Klemmen zu einer Stromversorgung 6a, 6b beziehungsweise 6c. Parallel dazu besteht eine Verbindung zu Meßwandlern 3a, 3b und 3c. Die Ausgangssignale dieser Spannungsanpassungen sind proportional reduzierte Werte der an diesen Spannungsanpassungen anliegenden Klemmenspannungen. Diese Spannungsanpassungen sind nur bei größeren Spannungen, im allgemeinen über 12 Volt, erforderlich. Sie stellen somit eine Bereichserweiterung der Meßschaltungen dar. Die Stromversorgung 6a liefert die Stromversorgung für die einzelnen Meßwandler 3a, 3b und 3c, beziehungsweise gegebenenfalls für Kopplungsglieder 4a, 4b und 4c, die den Ausgang der Meßwandler 3a, 3b und 3c bilden, sowie gegebenenfalls für Signaltrennelemente 5a, 5b und 5c, die zwischen die von einer Auswerteschaltung 10 kommende Steuerleitung 9 und die Meßwandler 3a, 3b und 3c geschaltet sind. Je nach Art der verwendeten Kopplungsglieder 4a, 4b und 4c sowie der Signaltrennelemente 5a, 5b und 5c ist eine derartige Stromversorgung erforderlich oder nicht. Beispielsweise benötigen die bevorzugt eingesetzten Optokoppler als Kopplungsglieder keine eigene Stromversorgung.

Von einer nicht dargestellten, im Ausführungsbeispiel gemäß Figur 1 innerhalb der Auswerteschaltung 10 angeordneten Steuerung werden über eine Steuerleitung 9 Startsignale geliefert und den Signaltrennelementen 5a, 5b und 5c zugeführt. Im gezeigten Ausführungsbeispiel, welches zunächst ohne die Steuerleitungsabschnitte 9d, 9e, 9f ausgeführt sei, erfolgt diese Steuersignalübermittlung von einer Meßschaltung zu der nächsten Meßschaltung und von der letzten Meßschaltung wird die Steuerleitung 9c zu der innerhalb der Auswerteschaltung 10 angeordneten Steuerung zurückgeführt. Das Ausgangssignal des Signaltrennelementes 5a der ersten Meßschaltung 1a löst innerhalb des Meßwandlers 3a die Messung der momentan anliegenden Meßwerte aus, beispielsweise der anliegenden Batteriespannung, des momentan aus der Batterie entnommenen Stromes, der Temperatur innerhalb der Batterie etc.

Der Meßwandler 3a wandelt die erhaltenen Meßsignale in entsprechende Spannungsimpulse einer Zeitdauer um, die der gemessenen Meßgröße proportional ist. Das Kopplungsglied 4a bewirkt die Weitergabe diese Spannungsimpulses an die gemeinsame Meßleitung 8 zur gemeinsamen Auswerteschaltung 10. Die Endflanke dieses Spannungsimpulses wird durch das Kopplungsglied 4a über eine Teil-Steuerleitung 9a zum Signaltrennelement 5b der nächstfolgenden Meßschaltung 1b weitergeleitet, wo in gleicher Weise der Meßvorgang ausgelöst wird. Die Endflanke des durch das entsprechende Kopplungsglied 4b gelieferten Spannungsimpulses steuert ihrerseits über eine Teil-Steuerleitung 9b das Signaltrennelement 5c der nächstfolgenden Meßschaltung 1c an und so weiter.

Sind auch die Steuerleitungsabschnitte 9d, 9e, 9f ausgeführt, so erfolgt die Übertragung von Meß-Steuersignalen an die einzelnen Meßschaltungen 1a, 1b, 1c über einen jeder Schaltung zugeordneten Adreßcode.

Die Auswerteschaltung 10 liefert ein Signal, das eine Aussage über den momentanen Qualitätszustand einer Batterie liefert. Dieses Signal kann an eine Anzeigeeinrichtung 11 weitergegeben werden und von da gegebenenfalls auch weiter übertragen werden.

Im Ausführungsbeispiel von Figur 1 ist eine Batterie B mit drei einzelnen Zellen 2a, 2b und 2c dargestellt. Stattdessen kann auch eine beliebig höhere Anzahl von Zellen verwendet werden. Beispielsweise werden für eine 220 Volt-Batterie 110 2V-Zellen benötigt.

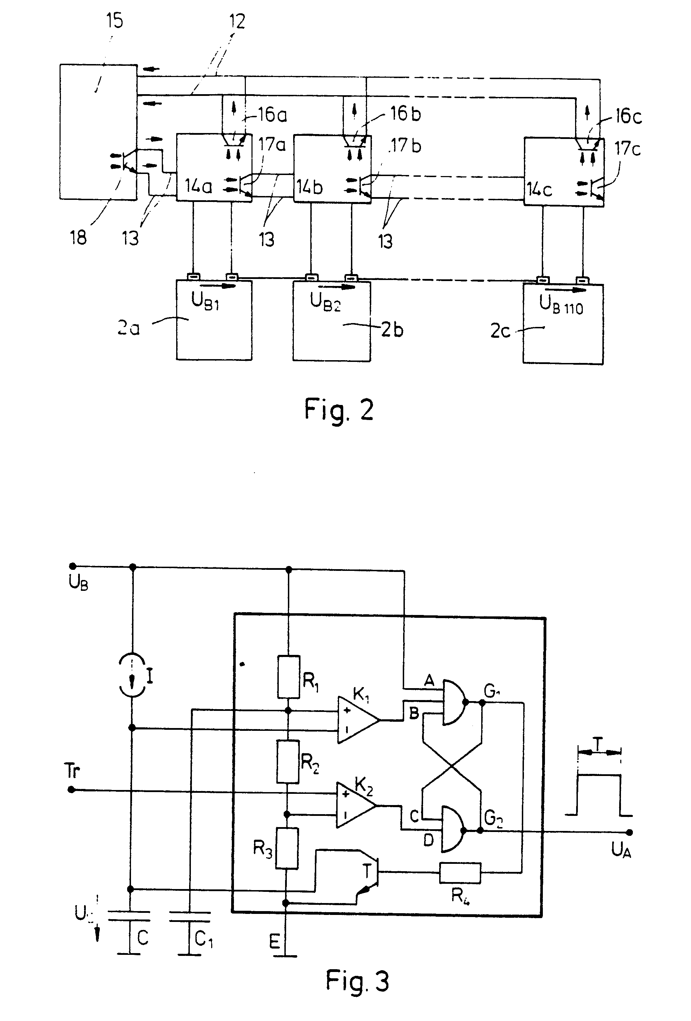

Figur 2 zeigt in schematischer Darstellung ein Ausführungsbeispiel, bei dem eine zweiadrige Meßleitung 12 vorgesehen ist, die mit jeder Meßschaltung 14a, 14b, 14c über je einen Meßsignal-Optokoppler 16a, 16b, 16c verbunden ist. Die einzelnen Meßsignale werden der Auswerteschaltung in Form eines Rechners 15 zugeführt. Innerhalb des Rechners 15 ist die Steuerung vorgesehen, die über einen ersten Steuersignal-Optokoppler 18 sowie über eine erste zweiadrige Steuerleitung 13a einen Ausgangs-Trigger-Steuerimpuls an die erste Meßschaltung 14a liefert, um die Messung der momentan an der zugehörigen ersten Zelle 2a anliegenden Meßwerte durchzuführen und über den ersten Opto-Koppler 16a an die gemeinsame Meßleitung 12 weiterzugeben. Wie weiter oben erwähnt, besteht das Meßsignal vorzugsweise aus einem Impuls mit einer Dauer, die dem gemessenen Wert proportional ist. Die Endflanke des Meßsignales wird gleichzeitig benutzt, um über einen ersten Steuersignal-Opto-Koppler 17a innerhalb der ersten Meßschaltung 14a und eine zweite Steuerleitung 13b, die mit der zweiten Meßschaltung 14b verbunden ist, die Messung der zugehörigen zweiten Zelle 2b durchzuführen, und so weiter.

Figur 3 zeigt einen bei dem Ausführungsbeispiel gemäß Figur 1 und Figur 2 einsetzbaren Schaltkreis zur Umwandlung der an den einzelnen Zellen anliegenden Spannung $U_B$ in einen Impuls mit zu $U_B$ proportionaler Dauer. Dies stellt ein bevorzugtes Ausführungsbeispiel für einen Meßwandler 3a, 3b, 3c gemäß Figur 1 beziehungsweise 14a, 14b, 14c gemäß Ausführungsbeispiel von Figur 2 dar.

Die an der Zelle anliegende Spannung $U_B$, deren Gegenpol am Punkt E mit Masse verbunden ist, wird über einen ersten Widerstand $R_1$ an den Plus-Anschluß eines ersten Operationsverstärkers $K_1$ angelegt, während der Minus-Anschluß dieses Operationsverstärkers über eine Konstantstromquelle mit dem gleichen Pluspol verbunden ist.

Der Plus-Anschluß eines zweiten Operationsverstärkers $K_2$ ist mit einem Triggereingang Tr verbunden, während der Minus-Anschluß dieses zweiten Operationsverstärkers $K_2$ über einen zweiten Widerstand $R_2$ mit dem Plus-Anschluß des ersten Operationsverstärkers $K_1$ verbunden ist. Der Negativ-Anschluß des zweiten Operationsverstärkers $K_2$ ist über einen dritten Widerstand $R_3$ mit dem Emitter-Anschluß eines Transistors T verbunden. Der Kollektoranschluß des Transistors T ist mit dem Negativ-Anschluß des ersten Operationsverstärkers $K_1$ verbunden. Sowohl dieser Anschluß als auch der Plus-Anschluß des ersten Operationsverstärkers $K_1$ ist über Kondensatoren C beziehungsweise $C_1$ mit Masse verbunden. Die Basis des Transistors T ist über einen Wider-

stand $R_4$ mit dem Ausgang eines ersten invertierenden UND-Gliedes $G_1$ verbunden. Ein erster Eingang des ersten invertierenden UND-Gliedes $G_1$ ist mit dem Pluspol der Zelle verbunden, ein zweiter Eingang B des ersten invertierenden UND-Gliedes ist mit dem Ausgang des ersten Operationsverstärkers $K_1$ verbunden.

Der Ausgang des ersten invertierenden UND-Gliedes $G_1$ ist mit einem ersten Eingang C eines zweiten invertierenden UND-Gliedes $G_2$ verbunden, während ein zweiter Eingang D des invertierenden UND-Gliedes $G_2$ mit dem Ausgang des zweiten Operationsverstärkers $K_2$ verbunden ist. Der Ausgang des zweiten invertierenden UND-Gliedes $G_2$ liefert das gesuchte Ausgangssignal des Meßwandlers in Form eines Rechteck-Impulses $U_A$, dessen Zeitdauer T dem am Meßwandler anliegenden Meßwert $U_B$ proportional ist.

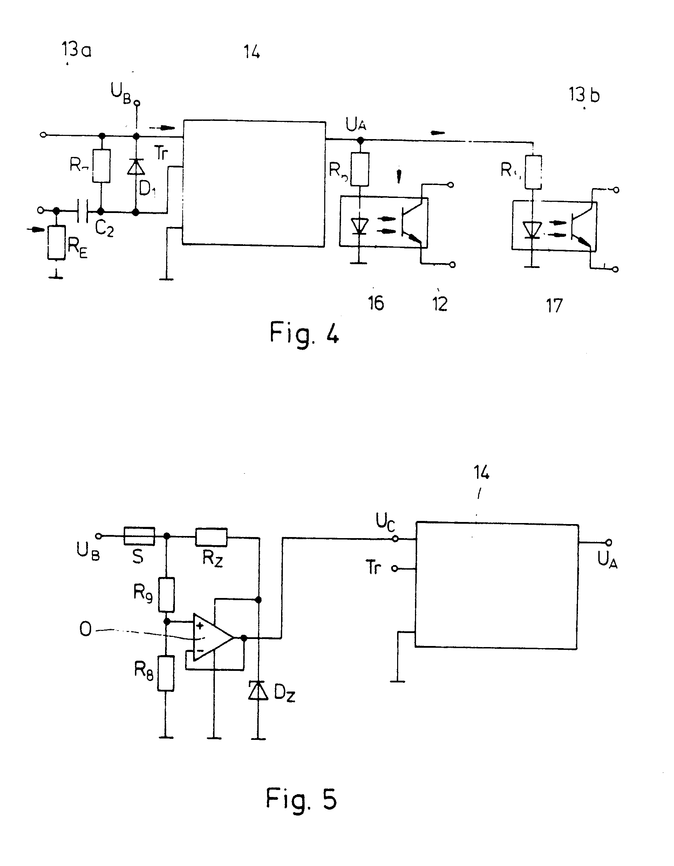

Figur 4 zeigt die schaltungsmäßige Zuordnung des Meßwandlers 14 innerhalb der Meßschaltung 1, wobei das Steuer-Auslösesignal von der Steuerleitung 13a dem Meßwandler 14 zugeführt wird, wobei das Ausgangssignal des Meßwandlers 14 in Form des dem Meßwert proportionalen Spannungsimpulses $U_A$ dem Meßsignal-Optokoppler 16 zugeführt wird, und wobei die Endflanke dieses Meßsignales zum Auslösen des Meßvorganges in der nächstfolgenden Zelle dient, indem über einen Vorwiderstand $R_5$ einem Steuersignal-Optokoppler 17 das Meßsignal zugeführt wird. Der Optokoppler 17 steht über eine zweite Steuerleitung 13b mit der Meßschaltung bzw. dem Meßwandler der nächsten Zelle in Verbindung (nicht gezeigt).

Die Zuführung des Meß-Startsignales, das durch eine Steuerung innerhalb des Rechners oder den Meßwandler der vorherliegenden Zelle erzeugt wird (nicht gezeigt), an den Meßwandler (14) erfolgt über ein Differenzierglied, bestehend aus Massewiderstand $R_E$, Kondensator $C_2$, Widerstand $R_7$ und Diode $D_1$, welches die Endflanke des über die Steuerleitung 13a eintreffenden Steuerimpulses in einen Triggerimpuls T umwandelt.

Figur 5 zeigt eine Anpassungsschaltung gemäß Figur 1, die zur Erweiterung des Meßbereiches für den Fall dient, daß mehrere Zellen an eine einzige Meßschaltung angeschlossen werden, wobei sich entsprechend höhere Meßwerte ergeben, insbesondere hinsichtlich der Batteriespannung und des Batteriestromes. Kernpunkt der Anpassungsschaltung 7 gemäß Figur 5 ist ein Operationsverstärker 0, dessen positiver Eingang + über eine Sicherung S und einen ersten Widerstand $R_9$ an die Klemmenspannung der Batterie angeschlossen ist, gleichzeitig ist der positive Anschluß über einen zweiten Vorwiderstand $R_8$ mit Masse verbunden. Der Negativ-Anschluß des Operationsverstärkers 0 ist mit dem Ausgang desselben verbunden, und somit stellt der Operationsverstärker 0 eine zur Klemmenspannung $U_B$ proportionale, belastbare Spannungsquelle $U_C$ dar.

Der Widerstand $R_Z$ und die Diode $D_Z$ dienen der Bereitstellung der Versorgungsspannung des Operationsverstärkers.

Der Ausgang des Operationsverstärkers 0 ist als Spannungssignal $U_C$ mit dem Meßwandler 14 verbunden und liefert das Ausgangssignal $U_A$ in Form eines Rechteck-Impulses bestimmer Zeitdauer, die dem Meßwert proportional ist.

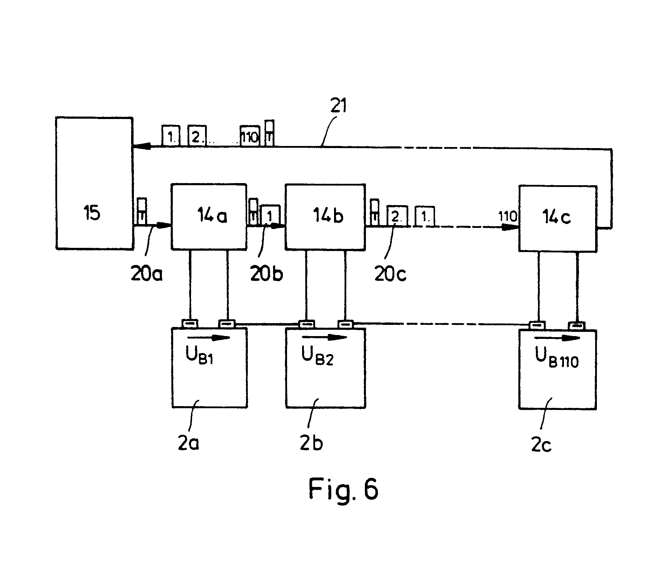

Figur 6 zeigt im Grundprinzip die in Figur 2 dargestellte schematische Gesamt-Meßanordnung, wobei gleiche beziehungsweise entsprechende Teile mit gleichen Bezugszeichen versehen sind. Als wesentlicher Unterschied ist die Schaltung der Steuerleitung sowie der Meßleitung anzusehen. Die gemeinsame Auswerteschaltung 15 in Form eines Rechners enthält die (nicht gezeigte) gemeinsame Steuerung und sendet über eine erste Steuerleitung 20a einen Startimpuls an die erste Meßschaltung 14a zur Auslösung der Messung an der ersten Zelle 2a. Sowohl das erhaltene Meßsignal als auch das Steuersignal zum Auslösen der Messung in der nächstkommenden Zelle 2b erfolgen über eine gemeinsame kombinierte zweite Steuer- und Meßleitung 20b zur zweiten Meßschaltung 14b und so weiter. Die letzte Meßschaltung 14c ist über eine gemeinsame Meßleitung 21 mit der Auswerteschaltung in Form des Rechners 15 verbunden. Auf diese Weise lassen sich sämtliche Meßvorgänge einer größeren Anlage mit einer einzigen Leitung durchführen. Dies ist in der vorhandenen agressiven Atmosphäre von besonderem Vorteil.

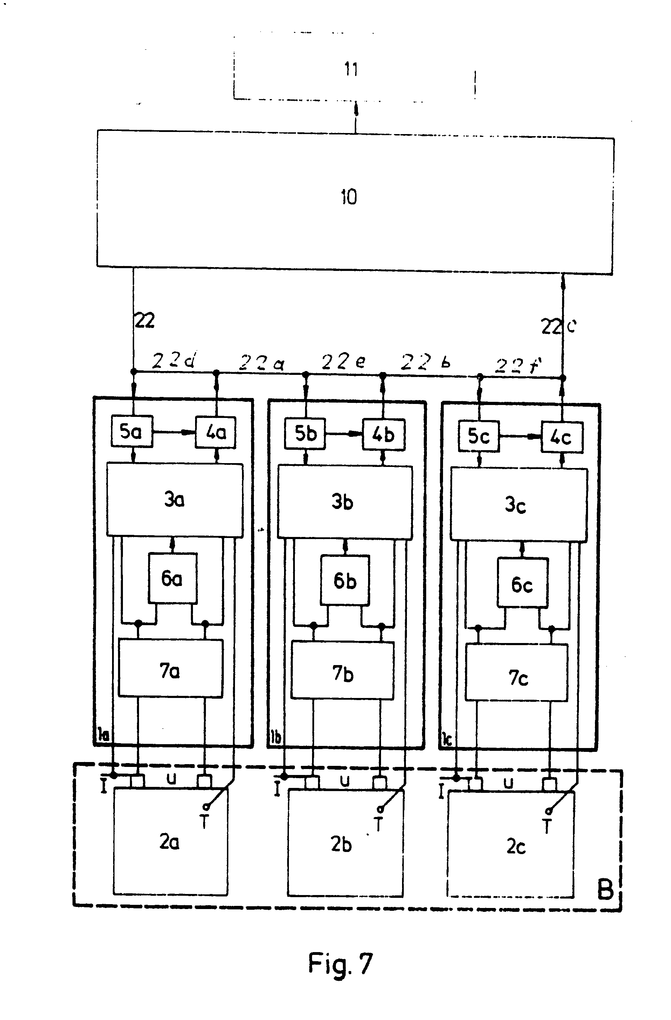

Figur 7 zeigt eine Anordnung, die im Prinzip der in Figur 1 entspricht beziehungsweise inhaltlich auch den Anordnungen gemäß Figur 2 und Figur 6. Der Unterschied besteht in einer einzigen, im wesentlichen ringförmigen Steuer-und Meßleitung 22, 22c, die von der Steuerung innerhalb der Auswerteschaltung 10 ausgeht und zu dieser zurückführt. Die einzelnen Meßschaltungen 1a, 1b und 1c werden über die zugehörigen Signaltrennelemente 5a, 5b, 5c zur Messung der zugehörigen Zellen angeregt. Das erhaltene Meßsignal wird dann über den Opto-Koppler 4a, 4b, 4c nacheinander auf die gemeinsame Leitung geführt. Das jeweilige Meßsignal löst gleichzeitig über die gemeinsame Leitung mit den Leitungsabschnitten 22d, 22a, 22e, 22b, 22f und das zugehörige Signaltrennelement 5b, 5c die Messung der nächstfolgenden zugehörigen Zelle aus.

Die praktische Durchführung kann beispielsweise so erfolgen, daß verschiedene Steuersignal verwendet werden, auf die jeweils nur ein spezielles Signaltrennelement anspricht. Dieses spezielle Steuersignal für jede Meßschaltung kann beispielsweise direkt in der Steuerung innerhalb der Auswerteschaltung 10, oder als Ausgangssignal des vorausgehenden Kopplungsgliedes 4a der vorher betätigten Meßschaltung erzeugt werden.

## Ansprüche

1. Schaltung zur laufenden Überprüfung der Qualität einer mehrzelligen Batterie (B), dadurch gekennzeichnet,

a) daß an jede Zelle (2a, 2b, 2c) oder an mehrere Gruppen von Zellen je eine Meßschaltung (1a, 1b, 1c; 14a, 14b, 14c) zur Messung von an jeder Zelle beziehungsweise Gruppe von Zellen anliegenden physikalischen oder chemischen Größen wie Spannung (U), Strom (I) oder Temperatur (T) angeschlossen ist,

b) daß der Ausgang jeder Meßschaltung (1a, 1b, 1c) an eine gemeinsame Meß-Leitung (8; 12; 21; 22) angeschlossen ist,

c) daß zwischen den Ausgang jeder Meßschaltung (1a, 1b, 1c) und der gemeinsamen Meß-Leitung (8) je ein Kopplungsglied (4a, 4b, 4c; 16a, 16b, 16c) geschaltet ist,

d) daß die gemeinsame Meß-Leitung (8) an eine gemeinsame Auswerte-Schaltung (10) angeschlossen ist,

e) daß eine mit der Auswerteschaltung (10) - schaltungsmäßig verbundene gemeinsame Steuerung vorgesehen ist, um über eine gemeinsame Steuerleitung (9) zyklusförmig nacheinander die einzelnen Meßschaltungen zur Messung und/oder Weitergabe der durch die einzelnen Meßschaltungen (1a, 1b, 1c) gemessenen Spannungs- und/oder Stromwerte und/oder Temperaturwerte und dergleichen an die gemeinsame Meß-Leitung (8) und von da an die gemeinsame Auswerte-Schaltung (10) zu aktivieren,

f) daß an den Ausgang der gemeinsamen Auswerte-Schaltung (10) eine Anzeigeeinrichtung (11) angeschlossen ist, die eine Anzeige entsprechend der Qualität der Batterie liefert.

2. Schaltung nach Anspruch 1, dadurch gekennzeichnet, daß die Stromversorgung (6a, 6b, 6c) jeder Meßschaltung (1a, 1b, 1c) an die zugeordnete Zelle (2a, 2b, 2c) oder Gruppe von Zellen angeschlossen ist.

3. Schaltung nach Anspruch 1 oder 2, dadurch gekennzeichnet, daß als Kopplungsglieder (4a, 4b, 4c) Optokoppler eingesetzt werden.

4. Schaltung nach einem der Ansprüche 1 bis 3, dadurch gekennzeichnet, daß als Auswerteschaltung (10) ein Rechner eingesetzt wird.

5. Schaltung nach einem der Ansprüche 1 bis 4, gekennzeichnet durch Signaltrennelemente (5a, 5b, 5c) am Steuersignal-Eingang jeder Meßschaltung (1a, 1b, 1c) um nacheinander die Ansteuerung der einzelnen Meßschaltungen oder der einzelnen Optokoppler zu ermöglichen, und um die anliegenden Meßsignale zeitlich nacheinander auf die gemeinsame Meß-Leitung (8) zu übertragen.

6. Schaltung nach einem der Ansprüche 1 bis 5, dadurch gekennzeichnet, daß die gemeinsame Steuerleitung (9, 13a) nur mit dem Eingang (5a) der ersten Meßschaltung (1a, 14a) verbunden ist, und daß die Eingänge (5b, 5c) nachfolgender Meßschaltungen (1b, 1c; 14b, 14c) jeweils nur mit den Ausgängen (4a, 4b) der vorhergehenden Meßschaltung (1a, 1b) über Teil-Steuerleitungen (9a, 9b, 13b, 13c) verbunden sind, wobei die letzte Meßschaltung (1c) über die gemeinsame Meß-Leitung (8) mit dem Eingang der gemeinsamen Auswerteschaltung (10) verbunden ist.

7. Schaltung nach einem der Ansprüche 1 bis 6, gekennzeichnet durch eine einzige kombinierte Leitung (20a, 20b, 20c; 21) zur Übertragung von Steuersignalen und Meßsignalen sowie durch derartige Signaltrennelemente (5a, 5b, 5c) der einzelnen Meßschaltungen (14a, 14b, 14c), daß ein ankommendes Meßsignal unverändert an die nächste Meßschaltung (14b, 14c) beziehungsweise die End-Meß-Leitung (21), weitergeleitet wird, daß ein ankommendes Steuersignal an der zugehörigen Meßschaltung einen Meßvorgang auslöst, wobei die einzelnen Meßsignale jeder Meßschaltung zyklisch nacheinander und Potential-getrennt an die gemeinsame Auswerteschaltung (10) geliefert werden, und wobei das Ende eines Meßsignales ein Steuersignal an das Signaltrennelement der nächsten Meßschaltung liefert.

8. Schaltung nach einem der Ansprüche 1 bis 7, dadurch gekennzeichnet, daß die Steuerleitung (9, 20) und/oder Meß-Leitung (8, 21) ein Lichtwellenleiter ist.

9.Schaltung nach einem der Ansprüche 1 bis 8, gekennzeichnet durch je einen Meßwandler (3a, 3b, 3c) in jeder Meßschaltung (1a, 1b, 1c), der je einen Spannungsimpuls einer Dauer auf die gemeinsame Meß-Leitung (8) überträgt, die dem Wert der gemessenen physikalischen oder chemischen Größe entspricht.

10.Schaltung nach einem der Ansprüche 1 bis 9, gekennzeichnet durch eine derartige Steuerleitung (13a, 13b, 13c), daß das Steuersignal von einer Meßschaltung (1a, 1b) zur nächstfolgenden Meßschaltung (1b, 1c) weitergeleitet wird.

11. Schaltung nach einem der Ansprüche 1 bis 10, dadurch gekennzeichnet, daß die über die kombinierte Steuer-und Meßleitung (20a - 20c; 21) übertragenen Steuer-und Meßsignale aufgrund der unterschiedlichen Zeitdauer oder Amplitude voneinander unterscheidbar sind.

12. Schaltung nach einem der Ansprüche 1 bis 11, dadurch gekennzeichnet, daß zwischen Steuer-Eingangsleitung (9; 22), die von der gemeinsamen Auswerteschaltung (10) zur ersten Meßschaltung (1a) führt, und der Steuer-Ausgangsleitung (9c; 22c) eine Verbindungsleitung besteht, die als gemeinsame Leitung über entsprechende Leitungs-Abschnitte (9d, 9a, 9e, 9b, 9f; 22d, 22a, 22e, 22b, 22f) mit den Eingängen und Ausgängen sämtlicher Meßschaltungen (1a, 1b, 1c) verbunden ist.

Fig. 1

Fig. 2

Fig. 3

Fig. 4

Fig. 5

Fig. 6

Fig. 7

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | DE-B-2 842 817 (SIEMENS AG) <br> * ganzes Dokument * | 1,2-4 | G 01 R 31/36 |
| A | | 5-7,9-12 | |
| X | US-A-4 280 097 (R.L. CAREY et al.) <br> * ganzes Dokument * | 1-4 | |
| A | | 5-12 | |
| A | US-A-4 352 067 (R.J. OTTONE) <br> * Zusammenfassung; Figur 1 * | 1-4 | |
| A | EP-A-0 112 242 (ELECTRICITE DE FRANCE) <br> * Anspruch 1; Figur * | | |

|  | RECHERCHIERTE SACHGEBIETE (Int. Cl.4) |
|---|---|
| | G 01 R 31/36 |

Der vorliegende Recherchenbericht wurde für alle Patentansprüche erstellt

| Recherchenort | Abschlußdatum der Recherche | Prüfer |
|---|---|---|
| BERLIN | 21-04-1988 | LEMMERICH J |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
........................................................
& : Mitglied der gleichen Patentfamilie, übereinstimmendes Dokument

EPO FORM 1503 03.82 (P0403)